# EUROPEAN PATENT SPECIFICATION

(11) **EP 3 476 746 B1**
(45) Date of publication and mention of the grant of the patent: **19.05.2021**
(21) Application number: 17198062.6
(22) Date of filing: 24.10.2017
(51) Int. Cl.: B64D 47/06

(54) **AIRCRAFT NAVIGATION LIGHT AND AIRCRAFT COMPRISING THE SAME**
FLUGZEUGNAVIGATIONSLICHT UND FLUGZEUG DAMIT
LUMIÈRE DE NAVIGATION D'AÉRONEF ET AÉRONEF LA COMPRENANT

(43) Date of publication of application: 01.05.2019
(73) Proprietor: Goodrich Lighting Systems GmbH, 59557 Lippstadt (DE)
(72) Inventor: JHA, Anil Kumar, 59557 Lippstadt (DE); HESSLING-VON HEIMEDAHL, Andre, 56073 Koblenz (DE)
(74) Representative: Schmitt-Nilson Schraud Waibel Wohlfrom Patentanwälte Partnerschaft mbB

(56) References cited:
- EP-A1- 3 181 459
- DE-A1-102013 013 164
- GB-A- 2 540 155
- US-A- 3 309 563
- US-A1- 2002 008 976
- US-A1- 2003 072 165
- US-A1- 2006 007 013
- US-B1- 6 507 290

## Description

The present invention relates to exterior aircraft lighting. In particular, it relates to an aircraft navigation light.

Almost all aircraft are equipped with exterior lighting systems. In particular, almost all aircraft are equipped with aircraft navigation lights, which alternatively may be called aircraft position lights. Aircraft navigation lights are configured for providing information about the current position, orientation and direction of flight of the aircraft, in order to avoid collisions in air and on the ground. As aircraft navigation lights are an essential safety feature of an aircraft, it is highly desirable that the failure probability of the aircraft navigation light system of an aircraft is very low.

GB 2 540 155 A discloses a navigation light comprising: i) an aerodynamically profiled housing adapted to be fittable to an essentially flat surface on an appropriate part of a movable apparatus, the housing enclosing: a) a light source or a means to access the light from a light source; b) an optical diffuser adapted to collect light from the source and having a part of its surface forming a window in and as an integral part of the aerodynamically profiled housing and further adapted so that concentrated light from the light source is diffused to give a uniform light output from said window over the particular solid angles as prescribed in the requirements for that particular type of moving apparatus at the specific location where the housing is sited said window having an essentially elongated form with the plane of elongation being essentially parallel to the surface on which the housing is mounted; and ii) a source of electrical power. The housing is profiled to present a small cross-sectional area in the forward direction to create the minimum aerodynamic resistance for the particular speed(s) of motion of the movable apparatus to which the navigation light is fitted and display the required intensity of light uniformly over the full solid angles prescribed. The light source provides light into the optical diffuser, which light is scattered and reflected internally and emitted only through the integral window of the profiled housing, the optical geometry of the optical diffuser and integral window being such that light is emitted only within the particularly prescribed solid angles and evenly over the whole of said particularly prescribed solid angles.

US 2003/072165 A1 describes a light for an aircraft. The light particularly serves as position light for an aircraft, preferably for being mounted to the rear end of an aircraft, such as, e.g., an airplane, and is provided with a luminous means for emitting light and a reflector arrangement. The luminous means comprises a first and a second light source which are substantially identical and respectively emit light within a light radiation solid angle with a central axis, the two light sources being arranged symmetrically to the preferential axis and the central axes of the light radiation solid angles being inclined so as to face each other. The reflector arrangement comprises a first and a second reflection surface allocated to the first and second light source, respectively, said reflection surfaces also being symmetrically arranged to the preferential axis and respectively provided with a light propagation limiting edge for limiting the light propagation range, within which light emitted directly by the respectively allocated light source emerges from the receiving room of the housing. The first reflection surface is arranged opposite to the first light source and the second reflection surface is arranged opposite to the second light source. The two reflection surfaces are oriented and/or configured such that light emitted by the one light source is reflected by the reflection surface allocated thereto past the light propagation limiting edge of the other reflection surface to increase the luminous intensity within the light propagation range of the other light source near the partial range defined by the light propagation limiting edge of the one reflection surface.

It would be beneficial to provide aircraft navigation lights that allow for the provision of a highly fail safe and space-efficient aircraft navigation light system.

The invention includes an aircraft navigation light according to claim 1 and a method of making an aircraft navigation light according to claim 15. Embodiments of the invention are given in the dependent claims.

The invention includes, in a first aspect, an aircraft navigation light with integrated redundancy having at least a selected minimum light output and comprising a first light source, a second light source, and a common optical system, which is configured for shaping an output light intensity distribution of the aircraft navigation light. The light emitted by each of the first and second light sources is modified by the common optical system. Each of the first and second light sources has an individual light output capacity, wherein the individual light output capacity of each of the first and second light sources alone is sufficient for providing the selected minimum light output of the aircraft navigation light.

The term selected minimum light output refers to minimum design specifications for the light output of the aircraft navigation light. In particular, the term selected minimum light output may refer to the nominal specifications of the aircraft navigation light, when mounted to the aircraft during manufacturing, or to regulatory requirements for aircraft navigation lights or to good practice guidelines for aircraft navigation lights. For example, the term selected minimum light output may refer to a light output that is in accordance with Federal Aviation Regulations sections 25.1385 through 25.1397, in particular in accordance with Federal Aviation Regulations sections 25.1391 and 25.1393. The light output, as generated by operating either the first light source or the second light source and as modified by the common optical system, is sufficient for providing the selected minimum light output of the aircraft navigation light. This sufficiency relates to the nominal light output of each of the first light source and the second light source, i.e. it relates to the light output provided by the first and second light sources not showing any signs of wear. It can also be said that the light output, as generated by operating either of the first light source or the second light source and as modified by the common optical system, meets the selected minimum light output of the aircraft navigation light.

An aircraft navigation light according to the invention provides a very low failure probability due to the redundancy of the first and second light sources. In particular, redundancy is given by providing two independent light sources, wherein every light source is capable of compensating a degeneration, malfunction or failure of the other light source. An aircraft navigation light according to an exemplary embodiment of the invention comprises only a single optical system commonly used by both light sources, leading to very low space requirements for the aircraft navigation light. As compared to previous approaches, where two full aircraft navigation lights have been provided besides each other for redundancy purposes, the costs and the space needed for providing a second optical system may be saved.

As a result, an aircraft navigation light according to the invention provides redundancy without doubling the costs and the installation space. Also, ancillary systems, such as wiring, may be simplified. For example, two power supply lines to two aircraft navigation lights may be replaced with one power supply line to one aircraft navigation light, while achieving the same amount of redundancy in light sources.

The common optical system has a defined nominal light source location, also referred to as reference point herein. The reference point is defined as the point at which a single light source should be placed in order to generate the optimal light output. The reference point may also be viewed as the light source location the optical system is designed for. According to the invention, each of the first and second light sources is positioned outside of said reference point.

In an embodiment, the first and second light sources are equally offset from the reference point. The first and second light sources in particular may be arranged symmetrically with respect to a symmetry axis of the common optical system and/or a symmetry axis of the aircraft navigation light. The term symmetry axis does not require perfect symmetry between the two halves of the common optical system / of the aircraft navigation light. Rather, the term symmetry axis is meant to describe that the two halves of the common optical element / of the aircraft navigation light have substantially the same optical effect on a light source arranged on the symmetry axis. In such a system, the light emitted by the first and second light sources is modified equivalently by the common optical system. Thus, the aircraft navigation light may be operated equivalently by operating any of the first and second light sources, only with the light outputs being mirror images of each other. In particular, each of the first and second light sources may replace the other light source, if necessary, with the light output of the aircraft navigation light only being mirrored. In a particular embodiment, the first and second light sources are offset from the reference point by less than 10 mm. By keeping the offset small, the mirror images of the light output of the first and second light sources may be kept very similar to each other.

In an embodiment, the aircraft navigation light further comprises a control unit which is configured for controlling the operation of the first and second light sources. The control unit in particular may be configured for switching between operating (only) the first light source and operating (only) the second light source. The control unit further may be configured for operating both light sources simultaneously.

In an embodiment, the aircraft navigation light further comprises a near-end-of-life detector (NEOL-detector), in particular a single NEOL-detector, which is configured for detecting a light output level of each of the first and second light sources. A NEOL-detector allows switching the first and second light sources based on the detected light emission of at least one of the first and second light sources. It in particular allows switching from operating (only) the first light source to operating (only) the second light source, and vice versa, in case the detected light emission drops below a predetermined threshold indicating that the end of life of the respective light source is approaching. Such a configuration allows ensuring the required minimum light emission of the aircraft navigation light in case the end of life of the respective light source is approaching. It also allows ensuring the required minimum light emission of the aircraft navigation light in case of a malfunction or failure of one of the first and second light sources.

In an embodiment, the common optical system comprises a transparent optical element that jointly encases the first and second light sources. The transparent optical element may be in direct contact with the first and second light sources. The common optical system in particular may comprise a transparent optical element jointly encasing the first and second light sources and the near-end-of-life detector. More particularly, the transparent optical element may be in direct contact with the first and second light sources and/or with the NEOL-detector. In other words, the transparent optical element may abut at least one of the light sources and the NEOL-detector, so that no air gap is present between the transparent optical element and the first and second light sources and/or the NEOL-detector. By eliminating any air gap between the transparent optical element and the first and second light sources, the number of material discontinuities along the travel path of the light is reduced. This minimizes the losses along the travel path. The same reasoning holds true for the interface between the transparent optical element and the NEOL-detector.

In an embodiment, each of the first and second light sources is an LED. In an alternative embodiment, each of the first and second light sources comprises at least one LED. Each light source in particular may comprise a plurality of LEDs in order to increase the intensity of the light emission. LEDs are reliable light sources, having a high efficiency and a long lifetime.

In an embodiment, the first and second light sources may be LEDs including a semiconductor light emitting diode covered by a silicone or plastic cover, as is common in the art. By providing the transparent optical element in direct contact with the plastic/silicone covered LED, for example by overmolding a transparent optical element made of silicone over the plastic/silicone covered LED, the losses at the interface may be eliminated or at least kept very small. For minimizing the losses at the interface, the silicone used for forming the transparent optical element may have a very similar or identical refractive index, as compared to the plastic/silicone cover of the LED.

In an embodiment, the transparent optical element is made of silicone having a refractive index of about 1.4.

In an embodiment, the transparent optical element has an internal reflection portion, which is configured for reflecting light from the first and second light sources towards the near-end-of-life-detector by internal reflection. The internal reflection portion in particular may be a total internal reflection portion reflecting the light by total internal reflection. Total internal reflection provides a very efficient reflection causing only small losses. Employing a total internal reflection portion therefore allows for a very efficient light detection.

In an embodiment, the first and second light sources are arranged on a common support plate, in particular on a common printed circuit board (PCB). Arranging the first and second light sources on a common support plate allows for a defined and mechanically stable arrangement of the first and second light sources. Using a printed circuit board as the support plate allows integrating electrical lines for supplying power to the first and second light sources and for electrically connecting the NEOL-detector to the support plate. Also, as compared to previous approaches with two aircraft navigation lights besides each other, the number of printed circuit boards may be reduced.

In an embodiment, the light emitted by any of the first and second light sources is reflected by a reflector, in particular by a common reflector. Using a common reflector saves the costs and the space needed for providing an additional reflector.

In an embodiment, the aircraft navigation light comprises a common shutter element, which is configured for blocking a portion of the light emitted by each of the first and second light sources. A shutter element allows reliably restricting the light emission to a predetermined angle. The common shutter element in particular may be a single shutter element. Using a common / single shutter element for both light sources saves the costs and the space needed for providing an additional shutter element.

In an embodiment, the aircraft navigation light comprises only the first light source and the second light source, i.e. it does not comprise any additional light sources besides the first and second light sources. Restricting the number of light sources to two minimizes the costs and the installation space of the aircraft navigation light while still providing the desired redundancy.

In an embodiment, the aircraft navigation light comprises more than two light sources in order to increase the intensity of light emission and/or the redundancy even further. More than two light sources still may be arranged symmetrically with respect to the reference point. The light sources for example may be arranged at the corner of a polygon centered at the reference point. In case of four light sources, the light sources for example may be arranged as a square centered at the reference point.

Exemplary embodiments of the invention further include an aircraft, such as an airplane or a helicopter, comprising at least one aircraft navigation light in accordance with any of the embodiments described above. The additional features, modifications, and effects, described above with respect to the aircraft navigation light, apply to the aircraft in an analogous manner.

In an embodiment, the aircraft navigation light is a forward navigation light which is configured for emitting light predominantly in a forward direction and/or in a lateral direction. A forward aircraft navigation may be positioned at a wing tip of an airplane or at the fuselage of a helicopter. The forward navigation light may be configured to emit red light or green light.

In an embodiment, the aircraft navigation light is a tail navigation light, also referred to as rear navigation light, which is configured for emitting light predominantly in a rearward direction. Such tail navigation light may be positioned at a tail end of an airplane or helicopter. The tail navigation light may be configured to emit white light.

The invention includes, in a second aspect, a method of making an aircraft navigation light with at least a selected minimum light output, comprising the following steps: providing a first light source; providing a second light source; providing a common optical element, which is configured for shaping an output light intensity distribution of the aircraft navigation light; and positioning the first light source and the second light source proximate the common optical element such that operation of either of the first and second light sources alone meets the selected minimum light output. The additional features, modifications, and technical effects, as described above with respect to any of the embodiments of the aircraft navigation light, apply to the method of making an aircraft navigation light in an analogous manner.

Exemplary embodiments of the invention are described in detail below with reference to the figures, wherein:
Fig. 1 depicts a schematic top view of an aircraft with three aircraft navigation lights.
Fig. 2 shows a schematic top view of a forward navigation light according to an exemplary embodiment of the invention.
Fig. 3 shows a schematic side view of the forward navigation light shown in Fig. 2.
Fig. 4 shows a schematic front view of the forward navigation light shown in Figs. 2 and 3.
Fig. 5 shows a perspective view of a tail navigation light according to an exemplary embodiment of the invention.
Fig. 6 shows a sectional view of the tail navigation light shown in Fig. 5.
Fig. 7 is a schematic circuit diagram of a control unit connected to a tail navigation light according to an exemplary embodiment of the invention.

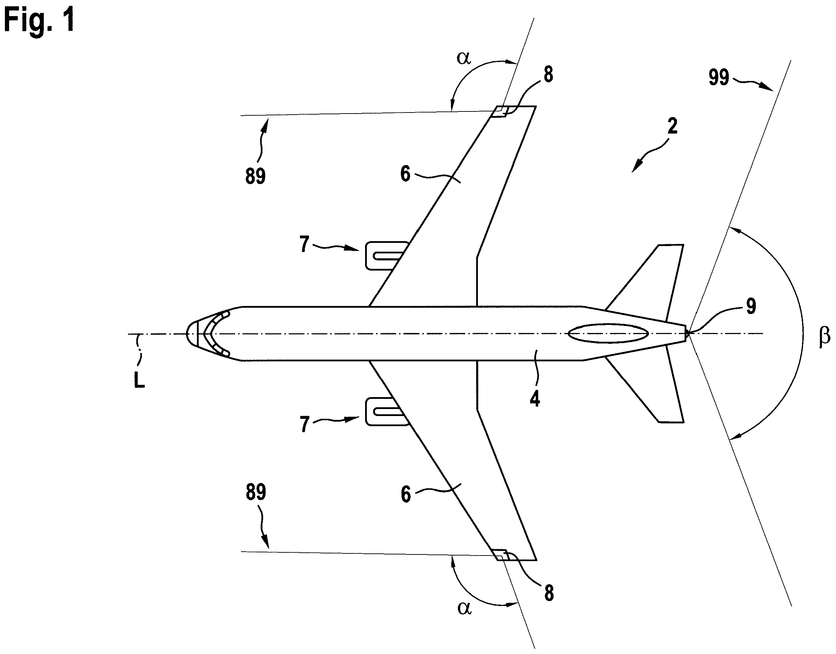

Fig. 1 depicts a schematic top view of an aircraft 2, in particular an airplane 2, comprising a fuselage 4 and two wings 6 extending laterally from the fuselage 4. An engine 7 is mounted to each of the wings 6, respectively.

The aircraft 2 is provided with three aircraft navigation lights 8, 9, which sometimes are called "aircraft position lights" 8, 9. The aircraft navigation lights 8, 9 include a tail navigation light 9, mounted to a tail end of the fuselage 4, and two forward navigation lights 8, respectively mounted to outer tip ends of the wings 6.

When projected onto a virtual horizontal plane (not shown), the light 89 emitted by the forward navigation lights 8 covers an area extending from the direction of flight (0°), which is parallel to a longitudinal axis L of the aircraft 4, outwardly over an angle α of 110°, i.e. 20° in the rearward direction. The forward navigation light 8 mounted to the starboard side, i.e. to the right side when viewed in the direction of flight, emits green light, and the forward navigation light 8 mounted to the port side, i.e. to the left side when viewed in the direction of flight, emits red light.

The tail navigation light 8 emits white light 99. The light emission 99 of the tail navigation light 8 extends over an angle β of 140° (+/- 70°) in the virtual horizontal plane. The light emission 99 of the tail navigation light 8 is centered around the longitudinal axis L of the aircraft 2.

Thus, the light emissions 89, 99 of the three aircraft navigation lights 8, 9, in combination, cover a full circle of 360° so that one of the three aircraft navigation lights 8, 9 is visible from any position around the aircraft 2.

The aircraft navigation lights 8, 9 are an essential safety feature of an aircraft 2 helping to avoid collisions between the aircraft 2 and other vehicles in air or on the ground. Thus, it is highly desirable that each aircraft navigation light 8, 9 is provided with redundancy in order to avoid a complete outage of any of the aircraft navigation lights 8, 9.

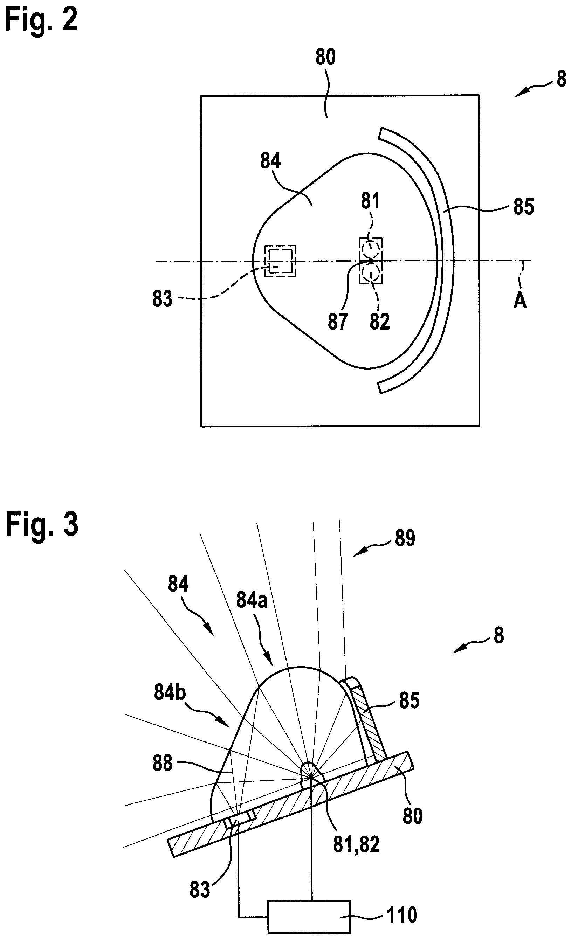

A forward navigation light 8 according to an exemplary embodiment of the invention providing the desired redundancy in an integrated manner within a single forward navigation light is shown in Figs. 2 to 4.

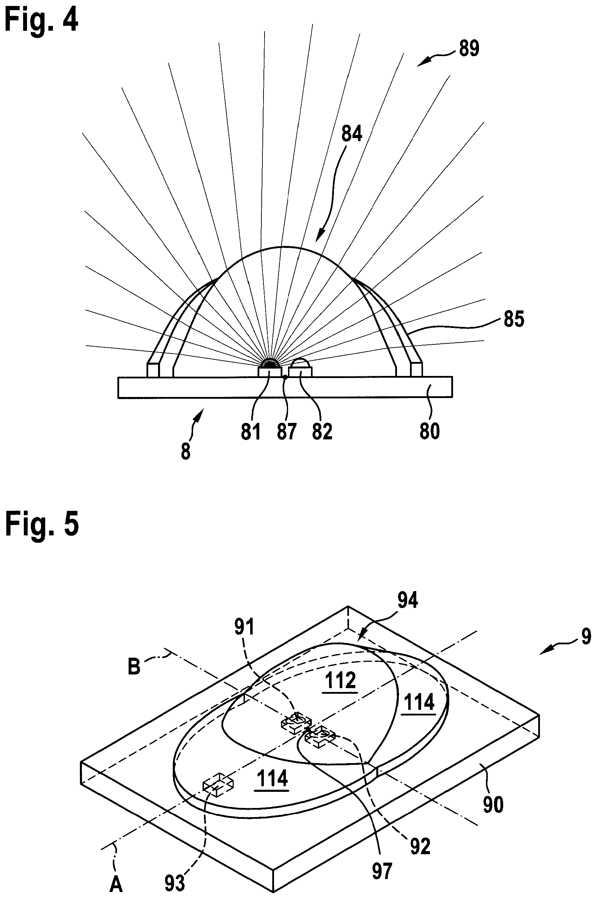

Fig. 2 shows a schematic top view of the forward navigation light 8, Fig. 3 shows a schematic side view, and Fig. 4 shows a schematic front view thereof.

The forward navigation light 8 comprises two light sources 81, 82, namely a first light source 81 and a second light source 82, mounted to a common support plate 80. Each of the first and second light sources 81, 82 may be an LED or may consist of multiple LEDs or may comprise at least one LED.

The common support plate 80 may be a printed circuit board (PCB), provided with electrical lines (not shown), which are configured for supplying electrical power to the first and second light sources 81, 82.

The first and second light sources 81, 82 are covered by a common, at least partially transparent optical element 84. The transparent optical element 84 in particular may be overmolded over the first and second light sources 81, 82. The transparent optical element 84 provides a transparent cover, covering and tightly encasing the first and second light sources 81, 82 with respect to the support plate 4.

The transparent optical element 84 may be made of silicone, in particular of silicon having a refractive index of about 1.4.

The transparent optical element 84 not only covers the first and second light sources 81, 82, but further constitutes a common optical system which is configured for shaping the distribution of light 89 emitted by the first and second light sources 81, 82.

The optical system provided by the transparent optical element 84 in particular may be configured to generate the desired light distribution 89 extending over an angle α of 110°, as it is shown in Fig. 1. The forward navigation light 8 additionally may be provided with a shutter element 85 which is configured to block any light 89 emitted beyond the direction of flight, i.e. configured to block any light towards the sector of the respectively other forward navigation light.

The shutter element 85 and the common optical system, provided by the transparent optical element 84, are formed symmetrically with respect to an axis A, shown in Fig. 2 and extending through the forward navigation light 8. The common optical system in particular is optimized for shaping the light emitted by a light source which is arranged at a nominal light source location 87, also referred to as reference point 87, as shown in Figs. 2 and 4 and located on said axis A.

In the embodiment shown in Figs. 2 to 4, none of the first and second light sources 81, 82 is arranged exactly at said reference point 87. Instead, both light sources 81, 82 are arranged symmetrically with respect to the axis A at the same distance from the reference point 87.

The optical system is designed so that small deviations of the positions of the light sources from the optimal reference point 87 do not considerably deteriorate the quality of the light emission 89 of the forward navigation light 8. I.e., the optical system and the first and second light sources 81, 82 are designed so that the desired light distribution 89 having the desired light intensity is generated and emitted by the forward navigation light 8 despite the fact that none of the first and second light sources 81, 82 is arranged exactly at the reference point 87. The optical system and the first and second light sources 81, 82 are even designed so that the operation of only one of the two light sources 81, 82 is sufficient for generating the desired light output 89 having the desired light intensity so that the additional light source 81, 82 provides the desired redundancy.

In addition to the first and second light sources 81, 82, a near end of life (NEOL) detector 83, which is a photodetector, is mounted to the support plate 80. The

NEOL-detector 83 is covered and tightly encased with respect to the support plate 4 by the same transparent optical element 84 as the first and second light sources 81, 82. The NEOL-detector 83 in particular is arranged on the axis A extending through the forward navigation light 8. As a result, the first and second light sources 81, 82 are arranged symmetrically with respect to the NEOL-detector 83.

In a region close to the shutter element 85 (on the right side of Figs. 2 and 3), the transparent optical element 84 has a curved portion 84a with a curved cross-section, which is shaped for providing the desired light distribution 89.

In a region more distant from the shutter element 85 (on the left side of Fig. 2 and 3), the transparent optical element 84 has a linear portion 84b with a linear cross-section, which also may contribute to generating the desired light distribution 89.

A portion 88 of the light emitted by the first and second light sources 81, 82 is reflected by the linear portion 84b of the cover 84 towards the NEOL-detector 8. Based on the amount of reflected light, which is detected by the NEOL-detector 83, the state of health of each of first and second light sources 81, 82 may be determined.

The linear portion 84b of the cover 84 may be a partially reflecting portion, which reflects only a percentage < 100% of the light hitting the linear portion 84b as indicated in Fig. 3. In an alternative embodiment, the linear portion 84b may be a total internal reflection portion, which is configured for reflecting all the light hitting the linear portion 84b.

A control unit 110 (see Fig. 3) is electrically connected with the NEOL-detector 83 and with the light sources 81, 82. The control unit 110 is configured for determining the state of health of the first and second light sources 81, 82. The control unit 110 is further configured for triggering appropriate countermeasures in case a weakness or a malfunction of at least one of the light sources 81, 82 is determined.

For example, in case only one of the two light sources 81, 82 is operated and a weakness or malfunction of said operated light source 81, 82 is determined, the control unit 110 may be configured to switch off the currently operated light source 81, 82 and to switch on the other light source 82, 81, which has not been operated before.

In case a problem, such as a reduced light emission due to wear, is detected for both light sources 81, 82, the control unit 110 may be configured to activate both light sources 81, 82 in order to combine the light emissions of the first and second light sources 81, 82 for increasing the total light emission 89 provided by the forward navigation light 8.

Alternatively or additionally, the control unit 110 may be configured to adjust the electrical current flowing through the operated light source(s) 81, 82 in order to adjust the light output provided by the light source(s) 81, 82.

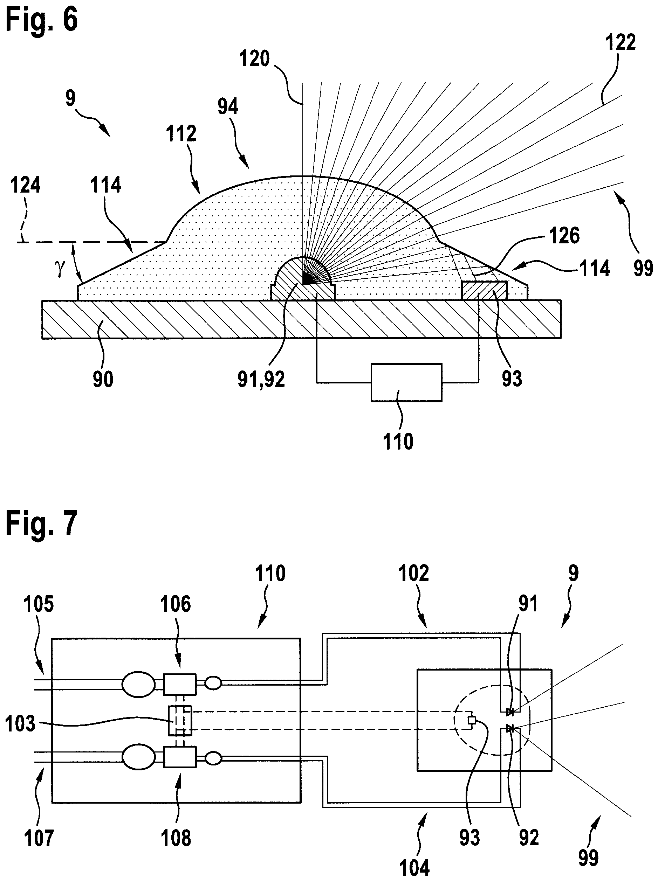

A tail navigation light 9 according to an exemplary embodiment is shown in Figs. 5 and 6.

Fig. 5 shows a perspective view of the tail navigation light 9, and Fig. 6 depicts a sectional view along axis A shown in Fig. 5.

Similar to the forward navigation light 8 depicted in Figs. 2 to 4, the tail navigation light 9 comprises a support plate 90, which may be a printed circuit board (PCB), and two light sources 91, 92, including a first light source 91 and a second light source 92, mounted to said support plate 90. Each of the first and second light sources 91, 92 may be an LED or may consist of multiple LEDs or may comprise at least one LED.

The first and second light sources 91, 92 are arranged symmetrically with respect to the axis A. The axis A in particular may be oriented horizontally when the tail navigation light 9 is assembled to an aircraft 2.

The first and second light sources 91, 92 are covered by a common, at least partially transparent optical element 94, which is indicated by a dotted structure in Fig. 6. The transparent optical element 94 in particular may be overmolded over the first and second light sources 81, 82. The transparent optical element 94 covers and tightly encases the first and second light sources 91, 92 with respect to the support plate 4.

The transparent optical element 94 may be made of silicone, in particular of silicon having a refractive index of about 1.4.

The transparent optical element 94 not only covers the first and second light sources 91, 92, but further constitutes a common optical system shaping the distribution of light 99 emitted by the first and second light sources 91, 92.

The at least partially transparent optical element 94 in particular comprises a refractive outer surface portion 112 and two total internal reflection portions 114 surrounding the refractive outer surface portion 112. These portions 112, 114 in combination form an outer surface of the transparent optical element 94 facing away from the support plate 90. The geometries of the refractive outer surface portion 112 and the total internal reflection portions 114 will be described in more detail below.

The transparent optical element 94 is symmetrical with respect to an axis B, which runs through both light sources 91, 92 and which is oriented perpendicularly to the axis A. When the tail navigation light 9 is mounted to an aircraft 2, the axis B is a vertical axis.

In Fig. 6, the refraction action of the transparent optical element 94 is illustrated by a plurality of exemplary light rays 122. In order not to overcrowd Fig. 6, the exemplary light rays 122 are shown for only the half of the tail navigation light 9 which is depicted on the right side of Fig. 6. However, as the refractive outer surface portion 112 is symmetric with respect to the main light emission direction 120, it is apparent that corresponding light rays are refracted in an analogous manner on the left side of the tail navigation light 9.

The refractive outer surface portion 112 slightly narrows the light output from the first and second light sources 91, 92 to +/- 70°. It also reconfigures the angular distribution of the light, in order to meet a particular desired output light intensity distribution of the exemplary tail navigation light 9. The distribution between +70° and -70° in the output light intensity distribution of the tail navigation light 9 takes the fact into account that aircraft tail navigation lights 9 are often required to have an opening angle β of 140° in a horizontal plane, as it has been described with reference to Fig. 1.

All light emitted in an angular range of between -72° and -90° with respect to the main light emission direction 120 of the aircraft tail navigation light 9 hits the total internal reflection portion 114, shown towards the right in the drawing plane of Fig. 5. All this light experiences total internal reflection at the total internal reflection portion 114, as is illustrated by exemplary light rays 126. At least a percentage of the light reflected by the total internal reflection portion 114 is detected by a near-end-of-life detector 93, which will be discussed in more detail further below.

The optical system provided by the transparent optical element 94 is optimized for a light source arranged at a defined nominal light source location 97, also referred to as reference point 97, which is located at the intersection of the two axes A and B.

However, none of the first and second light sources 91, 92 is arranged exactly at said reference point 97. Instead, both light sources 91, 92 are shifted symmetrically, i.e. over the same distance, with respect to the axis A along the axis B from the reference point 97.

The optical system, provided by the transparent optical element 94, is designed so that such a (small) deviation of the positions of the first and second light sources 91, 92 from the reference point 97 does not considerably deteriorate the quality of the light emission 99 of the tail navigation light 9. I.e., the optical system and the first and second light sources 91, 92 are designed so that the required light distribution 99, having the desired light intensity, is generated by the tail navigation light 9 despite the fact that none of the first and second light sources 91, 92 is arranged exactly at the reference point 97. The optical system and the first and second light sources 91, 92 are even designed so that the operation of only one of the first and second light sources 91, 92 is sufficient for generating the desired light output 99 and the additional light source 91, 92 provides the desired redundancy.

As mentioned before, light leaving the first and second light sources 91, 92 in an angular range of between -72° and -90° with respect to the main light emission direction 120 is reflected by the total internal reflection portions 114 and at least a portion of the reflected light reaches the near end of life (NEOL) detector 93 provided on the support plate 90.

In the exemplary embodiment depicted in Figs. 5 and 6, the total internal reflection portion 114 forms a linear contour in the cross-sectional view of Fig. 6. The transparent optical element 94 is symmetrical with respect to axis B. Accordingly, a total internal reflection portion 114 is provided on each of the left hand side and the right hand side of the transparent optical element 94 in the viewing direction of Fig. 6. As the NEOL-detector 93 is provided only on the right hand side of the transparent optical element 94 in the viewing direction of Fig. 6, the total internal reflection portion 114 on the left hand side of Fig. 6 could also be dispensed with.

In the cross-section depicted in Fig. 6, the total internal reflection portion 114 is inclined at an angle γ with respect to a plane defined by the support plate 90. The angle γ is indicated with respect to horizontal line 124, which is oriented parallel to the support plate 90 and thus encloses the same angle γ with the total internal reflection portion 114 as the support plate 90.

In the exemplary embodiment depicted in Figs. 5 and 6, the inclination angle γ is about 26°. This inclination angle is chosen in such a way that the light rays leaving the light sources 91, 92 within the angular ranges of -90° to -72° and 72° to 90° experience total internal reflection, while at the same time the lateral extension of the transparent optical element 94 is kept small. It is apparent that the angle γ may be adapted to the particular application scenario, depending on the required/desired output angle β of the output light intensity distribution 99 and depending on the refractive index of the material of the transparent optical element 94.

The NEOL-detector 93 is arranged on the support plate 90 at a position on the axis A, i.e. at a position which is symmetrical with respect to the first and second light sources 91, 92. The NEOL-detector 93 is covered and tightly encased by the same transparent optical element 94 as the first and second light sources 91, 92.

The NEOL-detector 93, which is a photodetector, collects a percentage of the reflected light, with some of the light passing by the NEOL-detector 93 due to its limited extensions. In this way, a percentage of the light emitted by the first and second light sources 91, 92 reaches the NEOL-detector 93 after traveling through the transparent optical element 94, while experiencing total internal reflection at the total internal reflection portion 114 along the way.

The NEOL-detector 93 is configured for sensing the amount of light hitting a sensing surface of the NEOL-detector 93, which is an upper surface in the orientation shown in Figs. 5 and 6, and generating an electrical signal which is indicative of the amount of light detected. In this way, the signal provided by the NEOL-detector 93 is indicative of the light output level of the first and second light sources 91, 92.

Similar to the forward navigation light 8 described before, a control unit 110, which is electrically connected with the NEOL-detector 93 and with the first and second light sources 91, 92, determines the current status of health of the first and second light sources 91, 92 from the signal provided by the NEOL-detector 93 and triggers appropriate countermeasures in case a weakness or malfunction of at least one of the first and second light sources 91, 92 is determined.

E.g. in case only one of the first and second light sources 91, 92 is operated and a weakness or malfunction of said at least one operated light source 91, 92 is determined, the control unit 110 may be configured to switch off the currently operated light source 91, 92 and switch on the other of the first and second light sources 91, 92, which has not been operated before.

In case a problem, such as a reduced light emission, is detected for both light sources 91, 92, the control unit 110 may be configured to switch on both light sources 91, 92 in order to combine the light emissions of the first and second light sources 91, 92 for increasing the total light emission 99 provided by the tail navigation light 9.

Alternatively or additionally, the control unit 110 may be configured to adjust the current flowing through the operated light source(s) 91, 92, in order to adjust the light output provided by the light source(s) 91, 92.

Fig. 7 is a schematic circuit diagram of a control unit 110 connected to a tail navigation light 9. It is understood that, instead of a tail navigation light 9, a forward navigation light 8, as it has been discussed with reference to Fig. 2 to 4, may be connected to a control unit 110 in the same manner.

The control unit 110 comprises two power inputs 105, 107, one power input 105, 107 for each of the first and second light sources 91, 92 of the tail navigation light 9. In an alternative embodiment, which is not shown in the figures, a single (common) power input may be provided for both light sources 91, 92.

The control unit 110 is further connected with two power output lines 102, 104, a first power output line 102 connecting the control unit 110 with the first light source 91, and a second power output line 104 connecting the control unit 110 with the second light source 92.

Power control units 106, 108 are arranged between the power inputs 105, 107 and the power output lines 102, 104. In particular, a first power control unit 106 controls the power supplied to the first light source 91 via the first power output line 102, and a second power control unit 108 controls the power supplied to the second light source 92 via the second power output line 104.

A control circuit 103 is connected to the two power control units 106, 108. The control circuit 103 is further connected to the NEOL-detector 93 of the tail navigation light 9. The control circuit 103 is configured for controlling the two power control units 106, 108 based on the signal provided by the NEOL-detector 93.

In particular, in case only one of the first and second light sources 91, 92 is operated and a weakness or malfunction of said operated light source 91, 92 is detected, the control circuit 103 may be configured to switch off the currently operated power control unit 106 and to switch on the other power control unit 108, which has not been operated before, in order to switch from operating the first light source 91 to operating the second light source 92. Of course, the control circuit 103 similarly may switch from operating the second light source 92 to operating the first light source 91 in case the second light source 92 is operated and a problem with the second light source 92 is detected.

In case a problem, such as a reduced light emission, is detected for both light sources 91, 92, the control circuit 102 may be configured to activate both power control units 106, 108, in order to operate both light sources 91, 92 simultaneously for combining the light emissions of the first and second light sources 91, 92, in order to increase the total light emission 99 provided by the tail navigation light 9.

With the aircraft navigation lights according to exemplary embodiments of the invention, as described above, a beneficial tradeoff between failure safety due to redundancy, space efficiency, and a low number of components has been achieved. As compared to previous approaches, where two entirely separate aircraft navigation lights have been provided side-by-side, the same light source redundancy is provided. While the mechanical redundancy is somewhat worse than in such previous approaches, because there is for example only one common optical element, the unchanged light source redundancy and the high space efficiency provide for a very favorable aircraft navigation light construction.

While the invention has been described with reference to exemplary embodiments, it will be understood by those skilled in the art that various changes may be made without departing from the scope of the invention. In addition, many modifications may be made to adapt a particular situation or material to the teachings of the invention without departing from the essential scope thereof. Therefore, it is intended that the invention not be limited to the particular embodiment disclosed, but that the invention will include all embodiments falling within the scope of the appended claims.

## Claims

1. Aircraft navigation light (8; 9) with integrated redundancy having at least a selected minimum light output, comprising:
a first light source (81; 91);
a second light source (82; 92); and
a common optical element (84; 94), which is configured for shaping an output light intensity distribution (89; 99) of the aircraft navigation light (8; 9);
wherein light emitted by each of the first light source (81; 91) and the second light source (82; 92) is modified by the common optical element (84; 94);
wherein each of the first and second light sources (82; 92) has an individual light output capacity,
**characterized in that** the individual light output capacity of each of the first and second light sources (81, 82; 91, 92) alone is sufficient for providing the selected minimum light output (89; 99) of the aircraft navigation light (8, 9),
wherein the common optical element (84; 94) has a defined nominal light source location (87), which is defined as a single light source location the common optical element (84; 94) is designed for; and each of the first and second light sources (81, 82; 91, 92) is positioned outside of the nominal light source location (87).

2. Aircraft navigation light (8; 9) according to claim 1, wherein each of the first light sources (81; 91) and the second light source (82; 92) is an LED.

3. Aircraft navigation light (8; 9) according to claim 1 or 2, wherein the first (81; 91) and second (82; 92) light sources are equally offset from the nominal light source location (87).

4. Aircraft navigation light (8; 9) according to any of the preceding claims, wherein the first and second light sources (81, 82; 91, 92) are arranged symmetrically with respect to a symmetry axis of the common optical element (84; 94) and/ or of the aircraft navigation light (8; 9).

5. Aircraft navigation light (8; 9) according to any of the preceding claims, wherein the common optical element (84; 94) comprises a transparent optical element that jointly encases the first (81; 91) and second (82; 92) light sources, wherein the transparent optical element in particular is in direct contact with the first and second light sources (81, 82; 91, 92).

6. Aircraft navigation light (8; 9) according to claim 5, further comprising a single near-end-of-life detector (83; 93), which is configured for detecting a light output (89; 99) level of each of the first and second light sources (81, 82; 91, 92).

7. Aircraft navigation light (8; 9) according to claim 6, wherein the transparent optical element jointly encases the first and second light sources (81, 82; 91, 92) and the near-end-of-life detector (83; 93), wherein the transparent optical element in particular is in direct contact with the first and second light sources (81, 82; 91, 92) and/or with the near-end-of-life detector (83; 93).

8. Aircraft navigation light (8; 9) according to claim 7, wherein the transparent optical element has an internal reflection portion (84b; 114), with light from the first and second light sources (81, 82; 91, 92) in particular being reflected by total internal reflection at the internal reflection portion (84b; 114) before reaching the near-end-of-life-detector (83; 93).

9. Aircraft navigation light (8; 9) according to any of claims 6 to 8, further comprising a control unit (110), configured to control the first and second light sources (81, 82; 91, 92) based on a signal provided by the near-end-of-life detector (83; 93).

10. Aircraft navigation light (8; 9) according to any of claims 6 to 9, configured for switching from a first mode, in which only the first light source (81; 91) is operated, into a second mode, in which only the second light source (82; 92) is operated, in case a near-end-of-life condition of the first light source (81; 91) is detected by the near-end-of-life detector (83; 93).

11. Aircraft navigation light (8; 9) according to any of claims 6 to 10, configured for switching into a third mode, in which the first and second light sources (81, 82; 91, 92) are operated simultaneously, in case near-end-of-life conditions of the first and second light sources (81, 82; 91, 92) are detected by the near-end-of-life detector (83; 93).

12. Aircraft navigation light (8; 9) according to any of the preceding claims, wherein the first and second light sources (81, 82; 91, 92) are arranged on a common printed circuit board.

13. Aircraft navigation light (8) according to any of the preceding claims, comprising a common shutter element (85), which is configured for blocking a portion of the light emitted by each of the first and second light sources (81, 82; 91, 92).

14. Aircraft (2), such as an airplane or a helicopter, comprising at least one aircraft navigation light (8; 9) according to any of the preceding claims.

15. Method of making an aircraft navigation light with at least a selected minimum light output, comprising the following steps:
providing a first light source (81; 91);
providing a second light source (82; 92);
providing a common optical element (84; 94), which is configured for shaping an output light intensity distribution (89; 99) of the aircraft navigation light (8; 9); wherein the common optical element (84; 94) has a defined nominal light source location (87), which is defined as a single light source location the common optical element (84; 94) is designed for; and
positioning the first light source (81; 91) and the second light source (82; 92) proximate the common optical element (84; 94) outside of the nominal light source location (87) such that operation of either of the first and second light sources alone meets the selected minimum light output.

## Patentansprüche

1. Luftfahrzeugnavigationsleuchte (8; 9) mit integrierter Redundanz, die mindestens eine definierte Mindestlichtabgabe aufweist, umfassend:
eine erste Lichtquelle (81; 91);
eine zweite Lichtquelle (82; 92); und
ein gemeinsames optisches Element (84; 94), welches zur Formung einer Ausgangslichtintensitätsverteilung (89; 99) der Luftfahrzeugnavigationsleuchte (8; 9) konfiguriert ist;
wobei durch jede der ersten Lichtquelle (81; 91) und der zweiten Lichtquelle (82; 92) emittiertes Licht durch das gemeinsame optische Element (84; 94) modifiziert wird;
wobei jede der ersten und zweiten Lichtquelle (82; 92) eine individuelle Lichtabgabekapazität aufweist,
**dadurch gekennzeichnet, dass**
die individuelle Lichtabgabekapazität von jeder der ersten und zweiten Lichtquelle (81, 82; 91, 92) allein ausreichend zur Bereitstellung der definierten Mindestlichtabgabe (89; 99) der Luftfahrzeugnavigationsleuchte (8, 9) ist,
wobei das gemeinsame optische Element (84; 94) einen definierten Nennlichtquellenstandort (87) aufweist, welcher als ein Einzellichtquellenstandort definiert ist, für den das gemeinsame optische Element (84; 94) konzipiert ist; und wobei jede der ersten und zweiten Lichtquelle (81, 82; 91, 92) außerhalb des Nennlichtquellenstandorts (87) positioniert ist.

2. Luftfahrzeugnavigationsleuchte (8; 9) nach Anspruch 1, wobei jede der ersten Lichtquelle (81; 91) und der zweiten Lichtquelle (82; 92) eine LED ist.

3. Luftfahrzeugnavigationsleuchte (8; 9) nach Anspruch 1 oder 2, wobei die erste (81; 91) und zweite (82; 92) Lichtquelle gleichmäßig von dem Nennlichtquellenstandort (87) versetzt sind.

4. Luftfahrzeugnavigationsleuchte (8; 9) nach einem der vorhergehenden Ansprüche, wobei die erste und zweite Lichtquelle (81, 82; 91, 92) symmetrisch in Bezug auf eine Symmetrieachse des gemeinsamen optischen Elements (84; 94) und/oder der Luftfahrzeugnavigationsleuchte (8; 9) angeordnet sind.

5. Luftfahrzeugnavigationsleuchte (8; 9) nach einem der vorhergehenden Ansprüche, wobei das gemeinsame optische Element (84; 94) ein transparentes optisches Element umfasst, das die erste (81; 91) und zweite (82; 92) Lichtquelle gemeinsam einschließt, wobei das transparente optische Element insbesondere in direktem Kontakt mit der ersten und zweiten Lichtquelle (81, 82; 91, 92) steht.

6. Luftfahrzeugnavigationsleuchte (8; 9) nach Anspruch 5, ferner umfassend einen einzelnen Detektor (83; 93) der nahezu abgelaufenen Lebensdauer, welcher zur Detektion eines Pegels der Lichtabgabe (89; 99) jeder der ersten und zweiten Lichtquelle (81, 82; 91, 92) konfiguriert ist.

7. Luftfahrzeugnavigationsleuchte (8; 9) nach Anspruch 6, wobei das transparente optische Element die erste und zweite Lichtquelle (81, 82; 91, 92) und den Detektor (83; 93) der nahezu abgelaufenen Lebensdauer gemeinsam einschließt, wobei das transparente optische Element insbesondere in direktem Kontakt mit der ersten und zweiten Lichtquelle (81, 82; 91, 92) und dem Detektor (83; 93) der nahezu abgelaufenen Lebensdauer steht.

8. Luftfahrzeugnavigationsleuchte (8; 9) nach Anspruch 7, wobei das transparente optische Element einen inneren Reflexionsabschnitt (84b; 114) aufweist, wobei Licht von der ersten und zweiten Lichtquelle (81, 82; 91, 92) insbesondere durch eine innere Totalreflexion an dem inneren Reflexionsabschnitt (84b; 114) reflektiert wird, bevor es den Detektor (83; 93) der nahezu abgelaufenen Lebensdauer erreicht.

9. Luftfahrzeugnavigationsleuchte (8; 9) nach einem der Ansprüche 6 bis 8, ferner umfassend eine Steuereinheit (110), die zum Steuern der ersten und zweiten Lichtquelle (81, 82; 91, 92) basierend auf einem Signal, das durch den Detektor (83; 93) der nahezu abgelaufenen Lebensdauer bereitgestellt wird, konfiguriert ist.

10. Luftfahrzeugnavigationsleuchte (8; 9) nach einem der Ansprüche 6 bis 9, das zur Schaltung von einem ersten Modus, in welchem nur die erste Lichtquelle (81; 91) betrieben wird, in einen zweiten Modus, in welchem nur die zweite Lichtquelle (82; 92) betrieben wird, konfiguriert ist, in dem Fall, dass eine Bedingung der nahezu abgelaufenen Lebensdauer der ersten Lichtquelle (81; 91) durch den Detektor (83; 93) der nahezu abgelaufenen Lebensdauer erfasst wird.

11. Luftfahrzeugnavigationsleuchte (8; 9) nach einem der Ansprüche 6 bis 10, das zur Schaltung in einen dritten Modus, in welchem die erste und zweite Lichtquelle (81, 82; 91, 92) gleichzeitig betrieben werden, konfiguriert ist, in dem Fall, dass Bedingungen der nahezu abgelaufenen Lebensdauer der ersten und zweiten Lichtquelle (81, 82; 91, 92) durch den Detektor (83; 93) der nahezu abgelaufenen Lebensdauer erfasst werden.

12. Luftfahrzeugnavigationsleuchte (8; 9) nach einem der vorhergehenden Ansprüche, wobei die erste und zweite Lichtquelle (81, 82; 91, 92) auf einer gemeinsamen gedruckten Leiterplatte angeordnet sind.

13. Luftfahrzeugnavigationsleuchte (8) nach einem der vorhergehenden Ansprüche, umfassend ein gemeinsames Blendenelement (85), welches zur Blockierung eines Teils des durch jede der ersten und zweiten Lichtquelle (81, 82; 91, 92) emittierten Lichts konfiguriert ist.

14. Luftfahrzeug (2), wie etwa ein Flugzeug oder ein Helikopter, umfassend mindestens eine Luftfahrzeugnavigationsleuchte (8; 9) nach einem der vorhergehenden Ansprüche.

15. Verfahren zur Herstellung einer Luftfahrzeugnavigationsleuchte mit mindestens einer definierten Mindestlichtabgabe, das die folgenden Schritte umfasst:
Bereitstellen einer ersten Lichtquelle (81; 91);
Bereitstellen einer zweiten Lichtquelle (82; 92);
Bereitstellen eines gemeinsamen optischen Elements (84; 94), welches zur Formung einer Ausgangslichtintensitätsverteilung (89; 99) der Luftfahrzeugnavigationsleuchte (8; 9) konfiguriert ist;
wobei das gemeinsame optische Element (84; 94) einen definierten Nennlichtquellenstandort (87) aufweist, welcher als ein Einzellichtquellenstandort definiert ist, für den das gemeinsame optische Element (84; 94) konzipiert ist; und
Positionieren der ersten Lichtquelle (81; 91) und der zweiten Lichtquelle (82; 92) derart in der Nähe des gemeinsamen optischen Elements (84; 94) außerhalb des Nennlichtquellenstandorts (87), dass der Betrieb von entweder der ersten oder der zweiten Lichtquelle allein die definierte Mindestlichtabgabe erfüllt.

## Revendications

1. Lumière de navigation d'aéronef (8 ; 9) avec redondance intégrée ayant au moins une sortie de lumière minimale sélectionnée, comprenant :
une première source lumineuse (81 ; 91) ;
une seconde source lumineuse (82 ; 92) ; et
un élément optique commun (84 ; 94), qui est conçu pour mettre en forme une distribution d'intensité lumineuse de sortie (89 ; 99) de la lumière de navigation d'aéronef (8 ; 9) ;
dans laquelle la lumière émise par chacune parmi la première source lumineuse (81 ; 91) et la seconde source lumineuse (82 ; 92) est modifiée par l'élément optique commun (84 ; 94) ;
dans laquelle chacune parmi les première et seconde sources lumineuses (82 ; 92) a une capacité de sortie de lumière individuelle,
**caractérisée en ce que**
la capacité de sortie de lumière individuelle de chacune parmi les première et seconde sources lumineuses (81, 82 ; 91, 92) seule est suffisante pour fournir la sortie de lumière minimale sélectionnée (89 ; 99) de la lumière de navigation d'aéronef (8, 9),
dans laquelle l'élément optique commun (84 ; 94) a un emplacement de source lumineuse nominale défini (87), qui est défini comme un emplacement de source lumineuse unique pour lequel l'élément optique commun (84 ; 94) est conçu ; et chacune des première et seconde sources lumineuses (81, 82 ; 91, 92) est positionnée à l'extérieur de l'emplacement de source lumineuse nominale (87).

2. Lumière de navigation d'aéronef (8 ; 9) selon la revendication 1, dans laquelle chacune parmi la première source lumineuse (81 ; 91) et la seconde source lumineuse (82 ; 92) est une DEL.

3. Lumière de navigation d'aéronef (8 ; 9) selon la revendication 1 ou 2, dans laquelle les première (81 ; 91) et seconde (82 ; 92) sources lumineuses sont décalées de manière égale par rapport à l'emplacement de source lumineuse nominale (87) .

4. Lumière de navigation d'aéronef (8 ; 9) selon l'une quelconque des revendications précédentes, dans laquelle les première et seconde sources lumineuses (81, 82 ; 91, 92) sont agencées symétriquement par rapport à un axe de symétrie de l'élément optique commun (84 ; 94) et/ou de la lumière de navigation d'aéronef (8 ; 9).

5. Lumière de navigation d'aéronef (8 ; 9) selon l'une quelconque des revendications précédentes, dans laquelle l'élément optique commun (84 ; 94) comprend un élément optique transparent qui renferme conjointement les première (81 ; 91) et seconde (82 ; 92) sources lumineuses, dans laquelle l'élément optique transparent en particulier est en contact direct avec les première et seconde sources lumineuses (81, 82 ; 91, 92).

6. Lumière de navigation d'aéronef (8 ; 9) selon la revendication 5, comprenant en outre un détecteur unique de fin de vie proche (83 ; 93), qui est conçu pour détecter un niveau de sortie de lumière (89 ; 99) de chacune des première et seconde sources lumineuses (81, 82 ; 91, 92).

7. Lumière de navigation d'aéronef (8 ; 9) selon la revendication 6, dans laquelle l'élément optique transparent renferme conjointement les première et seconde sources lumineuses (81, 82 ; 91, 92) et le détecteur de fin de vie proche (83 ; 93), dans laquelle l'élément optique transparent en particulier est en contact direct avec les première et seconde sources lumineuses (81, 82 ; 91, 92) et/ou avec le détecteur de fin de vie proche (83 ; 93).

8. Lumière de navigation d'aéronef (8 ; 9) selon la revendication 7, dans laquelle l'élément optique transparent a une partie de réflexion interne (84b ; 114), la lumière provenant des première et seconde sources lumineuses (81, 82 ; 91, 92) étant en particulier réfléchie par une réflexion interne totale au niveau de la partie de réflexion interne (84b ; 114) avant d'atteindre le détecteur de fin de vie proche (83 ; 93).

9. Lumière de navigation d'aéronef (8 ; 9) selon l'une quelconque des revendications 6 à 8, comprenant en outre une unité de commande (110), conçue pour commander les première et seconde sources lumineuses (81, 82 ; 91, 92) sur la base d'un signal fourni par le détecteur de fin de vie proche (83 ; 93).

10. Lumière de navigation d'aéronef (8 ; 9) selon l'une quelconque des revendications 6 à 9, conçue pour passer d'un premier mode, dans lequel seule la première source lumineuse (81 ; 91) est actionnée, à un deuxième mode, dans lequel seule la seconde source lumineuse (82 ; 92) est actionnée, dans le cas où une condition de fin de vie proche de la première source lumineuse (81 ; 91) est détectée par le détecteur de fin de vie proche (83 ; 93).

11. Lumière de navigation d'aéronef (8 ; 9) selon l'une quelconque des revendications 6 à 10, conçue pour passer à un troisième mode, dans lequel les première et seconde sources lumineuses (81, 82 ; 91, 92) sont actionnées simultanément, dans le cas où des conditions de fin de vie proche des première et seconde sources lumineuses (81, 82 ; 91, 92) sont détectées par le détecteur de fin de vie proche (83 ; 93).

12. Lumière de navigation d'aéronef (8 ; 9) selon l'une quelconque des revendications précédentes, dans laquelle les première et seconde sources lumineuses (81, 82 ; 91, 92) sont agencées sur une carte de circuit imprimé commune.

13. Lumière de navigation d'aéronef (8) selon l'une quelconque des revendications précédentes, comprenant un élément d'obturation commun (85), qui est conçu pour bloquer une partie de la lumière émise par chacune des première et seconde sources lumineuses (81, 82 ; 91, 92).

14. Aéronef (2), tel qu'un avion ou un hélicoptère, comprenant au moins une lumière de navigation d'aéronef (8 ; 9) selon l'une quelconque des revendications précédentes.

15. Procédé de fabrication d'une lumière de navigation d'aéronef avec au moins une sortie de lumière minimale sélectionnée, comprenant les étapes suivantes :
la fourniture d'une première source lumineuse (81 ; 91) ;
la fourniture d'une seconde source lumineuse (82 ; 92) ;
la fourniture d'un élément optique commun (84 ; 94), qui est conçu pour mettre en forme une distribution d'intensité lumineuse de sortie (89 ; 99) de la lumière de navigation d'aéronef (8 ; 9) ; dans lequel l'élément optique commun (84 ; 94) a un emplacement de source lumineuse nominale défini (87), qui est défini comme un emplacement de source lumineuse unique pour lequel l'élément optique commun (84 ; 94) est conçu ; et le positionnement de la première source lumineuse (81 ; 91) et de la seconde source lumineuse (82 ; 92) à proximité de l'élément optique commun (84 ; 94) à l'extérieur de l'emplacement de source lumineuse nominale (87) de sorte que le fonctionnement de l'une ou l'autre parmi les première et seconde sources lumineuses seule correspond à la sortie de lumière minimale sélectionnée.
